# EUROPÄISCHE PATENTSCHRIFT

(11) **EP 2 751 302 B1**
(45) Veröffentlichungstag und Bekanntmachung des Hinweises auf die Patenterteilung: **31.05.2017**
(21) Anmeldenummer: 12748180.2
(22) Anmeldetag: 02.08.2012
(51) Int. Cl.: F27B 14/10, H01L 31/18, C23C 18/12, C30B 11/00, C30B 15/10, C30B 35/00

(54) **SILIZIUMNITRIDHALTIGE TRENNSCHICHT HOHER HÄRTE**
SILICON-NITRIDE-CONTAINING INTERLAYER OF GREAT HARDNESS
COUCHE DE DÉMOULAGE CONTENANT DU NITRURE DE SILICIUM DE DURETÉ ÉLEVÉE

(30) Priorität: 31.08.2011 US 201161529552 P
(43) Veröffentlichungstag der Anmeldung: 09.07.2014
(73) Patentinhaber: 3M Innovative Properties Company, St. Paul, MN 55133-3427 (US)
(72) Erfinder: UIBEL, Krishna, 87437 Waltenhofen (DE); WORTHEY, David W., Monroe, Georgia 30656 (US)
(74) Vertreter: Mössner, Brigitte
(86) Internationale Anmeldenummer: PCT/EP2012/065182
(87) Internationale Veröffentlichungsnummer: WO 2013/029920

(56) Entgegenhaltungen:
- WO-A1-2007/039310
- DE-A1-102005 050 593
- DE-A1-102006 003 819
- DE-A1-102007 053 284
- HIDE I ET AL: "Mould shaping silicon crystal growth with a mould coating material by the spinning method", JOURNAL OF CRYSTAL GROWTH, ELSEVIER, AMSTERDAM, NL, Bd. 79, Nr. 1-3, 2. Dezember 1986 (1986-12-02), Seiten 583-589, XP024739688, ISSN: 0022-0248, DOI: 10.1016/0022-0248(86)90524-5 [gefunden am 1986-12-02]

## Beschreibung

### Technisches Gebiet

Die vorliegende Erfindung betrifft einen Formkörper, umfassend ein Substrat mit einer fest haftenden siliziumnitridhaltigen Trennschicht, welche abrieb-, stoß- und kratzfest sowie temperaturstabil ist, so dass der Formkörper transportstabil ist, ein Verfahren zur Herstellung eines solchen Formkörpers, eine Beschichtungssuspension zur Verwendung in einem solchen Verfahren sowie die Verwendung solcher Formkörper auf dem Gebiet der korrosiven Nichteisenmetallschmelzen, insbesondere als Schmelztiegel zur Anwendung im Bereich der Solar-Silizium-Verarbeitung.

### Hintergrund der Erfindung

Zum Erschmelzen und zur Rekristallisation von Siliziumblöcken (Ingots) aus Siliziumkörnungen, Siliziumgranulaten oder Siliziumstückgut werden Tiegel aus Graphit oder aus Siliziumnitrid, jedoch hauptsächlich aus SiO₂ (fused silica) verwendet. Über exakt definierte Abkühlvorgänge kristallisieren aus der Schmelze Ingots mit den gewünschten Gefügen und Reinheiten aus, die anschließend zu dünnen Scheiben geschnitten werden und den aktiven Bestandteil von Photovoltaikanlagen bilden.

Wesentlich ist hierbei, dass durch die bei der Verarbeitung verwendeten Materialien, wie Schmelztiegel, die Solar-Silizium-Qualität nicht negativ beeinträchtigt wird und die Siliziumschmelze defektfrei erstarren und unzerstört aus dem Tiegel entformt werden kann. In diesem Zusammenhang ist es wichtig, den korrosiven Angriff von flüssigem Siliziummetall auf das Tiegelmaterial zu verhindern, da die Schmelze sonst verunreinigt würde. Ferner führen Anhaftungen, Infiltration und Diffusion zu Problemen beim Entformen der Ingots, so dass die Gefahr eines Reißens oder Zerspringens des polykristallinen Siliziumblocks besteht.

Durch die korrosive Siliziumschmelze kommt es zu einem Angriff auf den SiO₂-Tiegel, da zwischen Si und SiO₂ eine chemische Reaktion unter Bildung von flüchtigem SiO stattfindet. Zudem gelangen auf diese Weise Sauerstoff und unerwünschte Verunreinigungen aus dem Tiegelmaterial in die Siliziumschmelze.

Insbesondere sind Anhaftungen des erstarrenden oder erstarrten Siliziumblocks unter allen Umständen zu vermeiden, da das Silizium sehr große thermische Ausdehnungen durchläuft, wobei kleinste Anhaftungen zu mechanischem Stress und damit zum Bruch der kristallinen Struktur führen, was einen Ausschuss an Siliziummaterial bedeutet.

### Stand der Technik

Aus EP 963 464 B1 sind mit Siliziumnitrid-Schichten versehene Schmelztiegel aus Quarz, Graphit oder Keramik zur Vermeidung von Verklebungen zwischen Schmelztiegel und Nichteisenmetallen nach Kontakt des Schmelztiegels mit erstarrenden Nichteisenmetallschmelzen, wie Siliziumschmelzen, bekannt, wobei die Schichten aus einem Siliziumnitrid-Pulver hoher Reinheit bestehen. Diese Pulverbeschichtungen werden direkt vom Anwender vor dem Einsatz der Schmelztiegel aufgebracht und dadurch hergestellt, dass man hochreines Siliziumnitrid-Pulver in einem Lösungsmittel dispergiert und dann beispielsweise durch Sprühen der Suspension auf die Tiegel aufbringt. Durch thermische Nachbehandlung müssen das Lösungsmittel und gegebenenfalls eingesetzte organische Binderbestandteile entfernt werden. Die Siliziumnitrid-Schichten der EP 963 464 B1 sind pulvrig und haben den Nachteil, dass sie nicht berührfest und mechanisch nicht stabil sind. Die Schichten besitzen eine geringe Härte und ihre Haftfestigkeit auf dem Tiegelsubstrat ist schlecht. Aufgrund der schlechten mechanischen Eigenschaften haben die Schichten den Nachteil, dass sie nicht transportstabil sind und daher erst beim Endanwender aufgebracht werden können (s. [0009] in WO 2007/039310 A1). Weiterhin sind die Schichten darin nachteilig, dass es zu Verschleppungen von Siliziumnitrid in den Silizium-Ingot kommt und dass bei der Beladung mit dem stückigen Silizium Defekte in der Beschichtung entstehen können.

Um diese Probleme zu beheben, wird in WO 2007/039310 A1 ein Schmelztiegel mit einer Beschichtung vorgeschlagen, welche aus 80 bis 95 Gew.-% Siliziumnitrid und 5 bis 20 Gew.-% eines mineralischen Niedertemperaturbinders besteht, wobei der Gesamtsauerstoffgehalt der Beschichtung im Bereich von 5 bis 15 Gew.-% liegt. Bei dem Niedertemperaturbinder handelt es sich vorzugsweise um einen SiO₂-basierten Binder, es kann aber auch Siliziumoxinitrid eingesetzt werden. Der mineralische Niedertemperaturbinder kann jedoch ebenso ein Sol-Gel-Binder oder eine auf der Siliziumchemie basierende organometallische Verbindung sein oder aus SiO₂-Nanopartikeln bestehen. Die Beschichtungen werden bei Temperaturen unterhalb 800 °C und vorzugsweise unterhalb 500 °C eingebrannt, um die Oxidation des Siliziumnitrids gering zu halten. Die Schichten besitzen eine geringe Härte und eine nur geringe Haftfestigkeit. Zudem sind die Schichten pulvrig und nicht berührfest. Der Sauerstoffgehalt der gebrauchsfertigen Beschichtung beträgt 5 bis 15 Gew.-%, vorzugsweise 8 bis 12 Gew.-%.

In der DE 10 2005 050 593 A1 wird eine Schlichte aus Siliziumnitrid und einem Bindemittel beschrieben zur Herstellung einer dauerhaften Hartbeschichtung, wobei das Bindemittel aus nanoskaligen Feststoffpartikeln und/oder Vorstufen davon aus der Herstellung über einen Sol-Gel-Prozess besteht. Die daraus herstellbaren Schichten haben eine bessere Haftfestigkeit und eine höhere Härte als die zuvor beschriebenen Schichten. Darüber hinaus sind die Schichten nicht pulvrig und berührfest. Diese Schichten sind darin nachteilig, dass sie für einen Großteil der Anwendungen, abhängig vom eingesetzten Rohsilizium und den jeweiligen Prozessbedingungen, einen zu hohen Sauerstoffgehalt von mehr als 10 Gew.-% aufweisen. Der theoretische Sauerstoffgehalt liegt höher, wird aber aufgrund von Verdampfung und Diffusion des Binders in das Substratmaterial nicht erreicht.

Bei den in WO 2007/039310 A1 und DE 10 2005 050 593 A1 beschriebenen Beschichtungsmethoden werden Sole bzw. keramische Vorstufen (wie Salze oder metallorganische Verbindungen) von SiO₂ eingesetzt, ob aktiviert (beispielsweise mit Säure, Base und/oder Wasser) oder unaktiviert. Es hat sich jedoch gezeigt, dass es mit diesen Beschichtungsmitteln unvermeidlicherweise zur Bildung von Defekten in der Beschichtung kommt.

Die bei den Beschichtungen auftretenden Schichtdefekte, wie Risse senkrecht zur Schichtoberfläche und insbesondere das "chipping" (schuppiges Absplittern der Beschichtung in der gesamten Tiefe einschließlich möglicherweise von Tiegelmaterial) bewirken, dass es während der Ingotherstellung zu Anhaftungen von Silizium am Tiegelmaterial kommen kann. Das "chipping" entsteht durch Risse im Bereich der Kontaktzone von Beschichtung und Substrat, die zu einer lokalen Ablösung der Beschichtung führen. Dadurch kann es beim Einsatz der Tiegel zu Anhaftungen der Metallschmelze an der Tiegelwand kommen, diese können sich noch verstärken, wenn es zur Unterwanderung der Beschichtung durch die Metallschmelze kommt. Die Anhaftungen von Silizium am Tiegelmaterial entstehen insbesondere während der Prozessphase, in der das Silizium im Tiegel flüssig ist. Je größer die Anhaftung ist bzw. je mehr Anhaftungen entstehen, desto größer wird das Risiko, dass Risse im Ingot während der Erstarrung entstehen, was die Ausbeute an verwertbarem Silizium für die Solarzellenherstellung reduziert.

Die Schichtdefekte werden durch die in der DE 10 2007 053 284 A1 vorgeschlagenen Beschichtungen weitestgehend vermieden. Die DE 10 2007 053 284 A1 offenbart eine Schlichte zur Herstellung einer dauerhaften, fest haftenden Trennschicht auf einem Substrat, umfassend eine Suspension von Feststoffteilchen, wobei die Feststoffteilchen 67 - 95 Gew.-% Silizumnitrid und 5 - 33 Gew.-% eines SiO₂-basierten Hochtemperaturbindemittels umfassen, wobei das SiO₂-basierte Hochtemperaturbindemittel aus SiO₂-Vorstufen abgeleitet ist und durch Temperaturbehandlung in einem Temperaturbereich von 300-1300°C vorbehandelt worden ist. Vorzugsweise erfolgt die Temperaturbehandlung des Hochtemperaturbindemittels zusammen mit dem Siliziumnitrid, so dass das Siliziumnitrid und das Hochtemperaturbindemittel in der Beschichtungssuspension und in der gebrauchsfertigen Beschichtung als Mischgranulat vorliegen.

Die in der DE 10 2007 053 284 A1 offenbarten Beschichtungen weisen Sauerstoffgehalte von 6 - 18 Gew.-% auf. Neben dem hohen Sauerstoffgehalt der Beschichtungen ist die DE 10 2007 053 284 A1 darin nachteilig, dass hier zunächst Granulate aus Bindemittel und Siliziumnitrid hergestellt werden müssen und diese anschließend noch einer Temperaturbehandlung bei 300 bis 1300 °C unterzogen werden müssen, bevor die Beschichtungssuspension hergestellt werden kann, so dass das Verfahren zur Herstellung dieser Beschichtungen insgesamt sehr aufwändig ist.

### Aufgabe der Erfindung

Der Erfindung liegt daher die Aufgabe zugrunde, einen Formkörper, umfassend ein Substrat mit einer fest haftenden Trennschicht vorzusehen, welche Trennschicht insbesondere geeignet ist für Anwendungen im Bereich der Solar-Silizium-Verarbeitung, ohne die im Stand der Technik bekannten Nachteile aufzuweisen, insbesondere defektfreie Beschichtungen mit hoher Abriebfestigkeit ermöglicht. Zudem soll ein einfaches und kostengünstiges Verfahren zur Herstellung eines solchen Formkörpers sowie eine Beschichtungssuspension zur Verwendung in einem solchen Verfahren vorgesehen werden.

### Zusammenfassung der Erfindung

Die oben genannte Aufgabe wird gelöst durch einen Formkörper, umfassend ein Substrat mit einer fest haftenden Trennschicht gemäß Anspruch 1, ein Verfahren zur Herstellung des Formkörpers gemäß Anspruch 5, eine Beschichtungssuspension zur Verwendung in einem solchen Verfahren gemäß Anspruch 14 sowie die Verwendung des Formkörpers auf dem Gebiet der korrosiven Nichteisenmetallschmelzen gemäß Anspruch 15.

Gegenstand der Erfindung ist somit ein Formkörper, umfassend ein Substrat mit einer fest haftenden Trennschicht, wobei die Trennschicht 92 - 98 Gew.-% Siliziumnitrid (Si₃N₄) und 2 - 8 Gew.-% Siliziumdioxid (SiO₂) umfasst, die Trennschicht einen Gesamtsauerstoffgehalt von ≤ 8 Gew.-% und eine Härte von wenigstens 10 HB 2,5/3 gemäß DIN EN ISO 6506-1 aufweist, und wobei die Trennschicht weiterhin einen Restgehalt eines Dotierstoffes in Form eines Flussmittels enthält, wobei der Dotierstoff eine Alkalimetallverbindung, vorzugsweise eine Natriumverbindung, umfasst. Gegenstand der Erfindung ist weiterhin ein Verfahren zur Herstellung eines erfindungsgemäßen Formkörpers, umfassend die Schritte:
a) Bereitstellen einer Si₃N₄ und ein Bindemittel auf SiO₂-Basis sowie einen Dotierstoff in Form eines Flussmittels umfassenden Beschichtungssuspension zur Herstellung einer fest haftenden Trennschicht, wobei der Dotierstoff der Beschichtungssuspension eine Alkalirnetallverbindung, vorzugsweise eine Natriumverbindung, umfasst,
b) Vorsehen eines Substrats
c) Auftragen der Beschichtungssuspension auf das Substrat, und
d) Härten der aufgetragenen Beschichtungssuspension durch Einbrennen bei einer erhöhten Temperatur zur Ausbildung einer fest haftenden Trennschicht.

Die Beschichtungssuspension in Schritt a) umfasst eine Suspension von Feststoffteilchen und dem Dotierstoff, wobei die Feststoffteilchen 88 - 98 Gew.-% Siliziumnitrid und 2 - 12 Gew.-% eines SiO₂-basierten Bindemittels umfassen. Das SiO₂-basierte Bindemittel besteht geeigneterweise aus partikulärem SiO₂ und/oder aus Verbindungen, die durch Einbrennen bei Temperaturen von ≥ 300 °C SiO₂ bilden. Die Mengenangaben des SiO₂-basierten Bindemittels beziehen sich auf die nach Temperaturbehandlung bzw. Pyrolyse des Bindemittels bei > 300 °C resultierenden Gehalte.

Gegenstand der Erfindung ist ebenso eine Beschichtungssuspension zur Verwendung bei der erfindungsgemäßen Herstellung eines Formkörpers, umfassend eine Suspension von Feststoffteilchen und einem Dotierstoff in Form eines Flussmittels in einem Dispergiermedium, wobei die Feststoffteilchen 88-98 Gew.-% Si₃N₄ und 2-12 Gew.-% eines SiO₂-basierten Bindemittels umfassen.

Gegenstand der Erfindung ist weiterhin die Verwendung eines erfindungsgemäßen Formkörpers auf dem Gebiet der korrosiven Nichteisenmetallschmelzen, insbesondere die Verwendung eines Formkörpers in Form eines Schmelztiegels zur Herstellung von Siliziumschmelzen.

Überraschenderweise hat sich gezeigt, dass sich mit dem erfindungsgemäßen Verfahren besonders harte und haftfeste Schichten mit niedrigen Sauerstoffgehalten und geringen Bindergehalten realisieren lassen.

Beschichtungen mit niedrigem Gesamtsauerstoffgehalt sind deshalb bevorzugt, weil bei hohen Sauerstoffgehalten die Diffusion von Sauerstoff in den Halbleiter (den Silizium-Ingot) hoch ist und weniger hochqualitatives Halbleiter-Material, insbesondere weniger hochqualitative Silizium-Ingots und damit weniger hochqualitative Silizium-Wafer für die Herstellung von Solarzellen erzeugt werden können.

Gegenüber den Beschichtungen der DE 10 2005 050 593 A1, der DE 10 2007 053 284 A1 und der WO 2007/039310 A1 konnte so der Nachteil überwunden werden, dass zu viel Sauerstoff in den Silizium-Ingot bei der Herstellung von Solar-Silizium gelangt. Dadurch erhöht sich die Ausbeute an sauerstoffarmem Silizium hoher Qualität aus der Ingotherstellung und der Wirkungsgrad der Solarzellen nimmt zu.

Besonders überraschend ist, dass der Dotierstoff bei Einbrenntemperaturen ab 1000°C ganz oder annähernd rückstandsfrei abdampft, während die unerwarteten Wirkungen des Dotierstoffs, nämlich die Spannungen in der Trennschicht abzubauen, eine gute Haftung zum Substrat zu erzeugen und die Härte zu erhöhen, auch ohne Anwesenheit bzw. bei nur geringen Restgehalten des Dotierstoffs verbleiben.

Besonders überraschend ist dabei auch, dass als Dotierstoff aus der Glasherstellung und - verarbeitung bekannte Flussmittel, die dort in Gehalten von einigen Prozent eingesetzt werden, hier im ppm-Bereich wirksam sind. Im Bereich der Glasherstellung und - verarbeitung verbleibt das Flussmittel bis zum Endprodukt im Glas, während es in den erfindungsgemäßen Beschichtungen bzw. Trennschichten während des Einbrennprozesses größtenteils transient sein kann.

Weiterhin konnten trotz des geringen Binderanteils und des niedrigen Sauerstoffgehalts in der Beschichtung, im Unterschied zu den Beschichtungen der EP 963 464 B1, transportstabile, berührfeste Schichten erhalten werden, bei denen es nicht zur Defektbildung beim Beladen mit stückigem Silizium kommt. Im Unterschied zu den Schichten der WO 2007/039310 A1 und der EP 963 464 B1 sind die erfindungsgemäßen Schichten nicht pulvrig.

Die erfindungsgemäßen Trennschichten zeichnen sich gegenüber allen zuvor beschriebenen Beschichtungen (DE 10 2005 050 593 A1, DE 10 2007 053 284 A1, EP 963 464 B1 und WO 2007/039310 A1) durch eine höhere Härte aus, bei gleichen oder niedrigeren Binder- und Sauerstoffgehalten.

Die erfindungsgemäßen Trennschichten haben eine gute Haftfestigkeit auf dem Substrat.

Die guten Schichteigenschaften führen zu hervorragenden prozessrelevanten Eigenschaften bei der Herstellung der Silizium-Ingots:
Aufgrund der nicht pulvrigen Schicht kommt es ebenso wie bei den Schichten der DE 10 2005 050 593 A1 und der DE 10 2007 053 284 A1 zu keiner bzw. nur einer geringen Kontamination des Silizium-Ingots durch Siliziumnitrid. Im Vergleich zu den pulvrigen Beschichtung gemäß EP 963 464 B1 und auch WO 2007/039310 A1 ist die Kontamination des Si-Ingots mit Siliziumnitrid bei den erfindungsgemäßen Beschichtungen jedoch deutlich geringer.

Die Beschichtung ist schlagunempfindlicher und ermöglicht bei Anwendungen für Schmelztiegel eine unproblematische stückige Beladung des beschichteten Tiegels, weiterhin ist auch die Beschichtung großer Tiegel möglich.

Beim Beladen des Tiegels oder beim Aufschmelzen von brockigem Silizium kann es generell zu Beschädigungen der Beschichtung kommen, sind nicht schon Inhomogenitäten oder Defekte in der Beschichtung bei der Applikation oder beim Einbrennen entstanden. Aufgrund der geringen Schichtfestigkeit und geringeren Adhäsion zum Substrat bei Beschichtungen gemäß EP 963464 B1 und WO 2007/039310 A1 ist der Schichtabtrag aufgrund von Stoß-, Scher-, Kratz- oder Reibbelastung hoch und es verbleibt eine dünne oder keine Restschicht. Die erfindungsgemäßen Schichten werden jedoch durch die mechanischen Beanspruchungen beim Beladen nicht, oder deutlich weniger beschädigt. Aufgrund der höheren Härte werden die erfindungsgemäßen Schichten beim Beladen auch weniger beschädigt als die Schichten der DE 10 2005 050 593 A1 und DE 10 2007 053 284 A1. Findet doch ein Schichtabtrag statt, ist dieser bei den erfindungsgemäßen Beschichtungen deutlich geringer, so dass die Trennwirkung und Funktion der Schicht gewährleistet bleibt.

Erstmals konnten mit den erfindungsgemäßen Beschichtungen nun Trennschichten mit hoher Haftfestigkeit und Binder- und Gesamtsauerstoffgehalten < 5 Gew.-% erhalten werden. Bei den bisher bekannten Schichten mit niedrigem Sauerstoffgehalt gemäß EP 963464 B1 und WO 2007/039310 A1 ist die Haftfestigkeit unzureichend (siehe [0019] in der WO 2007/039310 A1 und Referenzbeispiel 3 sowie Vergleichsbeispiele 1 und 2).

Die erfindungsgemäße Beschichtungssuspension lässt sich mit den bevorzugten Applikationsmethoden Tauchen, Fluten und Naß-in-Naß-Sprühen aufbringen. Diese Methoden sind deshalb bevorzugt, weil sich damit anders als beim Trockensprühen (pulvriger Auftrag) homogenere und dichtere Schichten erzeugen lassen. Durch diese Applikationsmethoden wird in den eingebrannten Beschichtungen die Porengröße in der Beschichtung kleiner und die Haft-, Stoß- und Kratzfestigkeit nimmt gegenüber pulverig applizierten Schichten zu. Die Beschichtung wird berührungsfest und transportstabil und die Kontamination des Ingots mit Schichtbestandteilen nimmt deutlich ab.

Durch die vereinfachte Auftragung mittels Fluten werden die Zeiten zur Applikation der Beschichtung auf dem Tiegelmaterial deutlich reduziert. Typischerweise dauert eine Sprühapplikation zur Herstellung pulveriger Schichten gemäß WO 2007/039310 A1 und EP 963 464 B1 auf einem Solartiegel 20-50 Minuten. Mit der erfindungsgemäßen Beschichtungssuspension dauert die Applikation über Fluten ca. 5-10 Minuten. Ebenfalls beschleunigt werden kann die Applikation durch Sprühen, die typischerweise 10-15 Minuten für einen Standardtiegel beträgt (z.B. mit einer Bodenfläche 690x690 mm² und Wandflächen von 690x400 mm²).

### Detaillierte Beschreibung der Erfindung

Die erfindungsgemäße Trennschicht enthält 92 - 98 Gew.-% Siliziumnitrid (Si₃N₄) und 2-8 Gew.-% Siliziumdioxid (SiO₂), vorzugsweise 94 - 98 Gew.-% Si₃N₄ und 2 - 6 Gew.-% SiO₂, und insbesondere bevorzugt > 95 - 97 Gew.-% Si₃N₄ und 3 - < 5 Gew.-% SiO₂.

Das SiO₂ ist in der erfindungsgemäßen Trennschicht ein Bindemittel für das Siliziumnitrid. Der SiO₂-Gehalt der Trennschicht kann ermittelt werden durch Analyse des Gesamtsauerstoffgehalts der Beschichtung und Umrechnung auf SiO₂.

Der Gesamtsauerstoffgehalt der Trennschicht beträgt ≤ 8 Gew.-%, vorzugsweise < 5 Gew.-%. Der Gesamtsauerstoffgehalt setzt sich zusammen aus dem Sauerstoff des SiO₂-Bindemittels, dem im Siliziumnitrid-Pulver unvermeidlicherweise enthaltenen Sauerstoff, sowie dem Sauerstoffgehalt, der beim Einbrennen der Beschichtung durch Oxidation des Siliziumnitrids entsteht.

Sofern der in der Beschichtungssuspension zur Herstellung der erfindungsgemäßen Trennschichten enthaltene Dotierstoff beim Härten der Beschichtungssuspension durch Einbrennen nicht vollkommen rückstandsfrei abdampft, kann die Trennschicht ebenfalls einen Restgehalt eines Dotierstoffes in Form eines Flussmittels enthalten.

Der Dotierstoff in Form eines Flussmittels ist vorzugsweise eine Alkalimetallverbindung, weiter vorzugsweise eine Natriumverbindung. Der Anteil des Dotierstoffs, ausgedrückt als Alkalimetallgehalt der Trennschicht, beträgt vorzugsweise bis zu 150 ppm, weiter vorzugsweise bis zu 50 ppm.

Die Härte der Trennschicht beträgt wenigstens 10 HBW 2,5/3 gemäß DIN EN ISO 6506-1, vorzugsweise wenigstens 15 HBW 2,5/3 und insbesondere bevorzugt wenigstens 20 HBW 2,5/3.

Es ist auch möglich, Schichten mit einem Gradient im Sauerstoffgehalt zu erzeugen, wobei die mit dem Halbleitermaterial, wie beispielsweise Solar-Silizium, im Kontakt stehende Schicht höchstens 8 Gew.-% Sauerstoff und bevorzugt weniger als 5 Gew.-% Sauerstoff enthält und gleichzeitig eine Härte HBW 2,5/3 von mindestens 10 besitzt.

Der erfindungsgemäße Formkörper kann hergestellt werden durch ein Verfahren, umfassend die Schritte:
a) Bereitstellen einer Si₃N₄ und ein Bindemittel auf SiO₂-Basis sowie einen Dotierstoff in Form eines Flussmittels umfassenden Beschichtungssuspension zur Herstellung einer fest haftenden Trennschicht,
b) Vorsehen eines Substrats,
c) Auftragen der Beschichtungssuspension auf das Substrat, und
d) Härten der aufgetragenen Beschichtungssuspension durch Einbrennen bei einer erhöhten Temperatur zur Ausbildung einer fest haftenden Trennschicht.

Die Beschichtungssuspension in Schritt a) umfasst vorzugsweise eine Suspension von Feststoffteilchen und dem Dotierstoff, wobei die Feststoffteilchen 88 - 98 Gew.-% Siliziumnitrid und 2 - 12 Gew.-% eines SiO₂-basierten Bindemittels umfassen.

Die Siliziumnitrid-haltige Beschichtungssuspension auf Basis von Wasser oder eines organischen Dispergiermediums enthält vorzugsweise hochreines Siliziumnitrid mit mittleren Partikel- oder Agglomeratgrößen (d₅₀) im Bereich von 0,5 - 20 µm, vorzugsweise 1 - µm und besonders bevorzugt 1,5 - 3 µm.

Das SiO₂-basierte Bindemittel in der Beschichtungssuspension ist beispielsweise abgeleitet aus Stoffen oder Stoffgemischen, die Siliziumdioxidvorstufen enthalten oder bilden oder bereits als Siliziumdioxid-Partikel oder als Mischung aus Vorstufen von Siliziumdioxid-Partikeln und Siliziumdioxid-Partikeln vorliegen und bei Pyrolyse bei ≥ 300 °C SiO₂ mit einer Reinheit von > 99,95 %, vorzugsweise > 99,99 % bilden. In der eingebrannten, gebrauchsfertigen Beschichtung liegt somit ein SiO₂-Bindemittel hoher Reinheit vor. In der Beschichtungssuspension liegt das erfindungsgemäße SiO₂-basierte Bindemittel vorzugsweise als nanodisperse Phase oder als Sol oder als keramische Vorstufen oder als Mischungen daraus vor (Precursor, Monomer, fraktale Anhäufungen von Monomeren oder Polykondensat).

Die Beschichtungssuspension bzw. das SiO₂-basierte Bindemittel in der Beschichtungssuspension enthält einen Dotierstoff. Der Dotierstoff ist ein Flussmittel für SiO₂. Flussmittel erniedrigen im allgemeinen den Schmelzpunkt oder den Erweichungspunkt von SiO₂ und setzen die Glastransformationstemperatur herab. Bevorzugt werden Flussmittel, die den Schmelzpunkt oder den Erweichungspunkt des SiO₂ besonders stark herabsetzen und dies bereits mit nur geringen Gehalten bewirken können. Als Dotierstoff werden bevorzugt Stoffe oder Stoffgemische, die Alkalimetallverbindungen enthalten, eingesetzt, beispielsweise Alkalicarbonate wie Kalium- oder Natriumcarbonat oder auch Natron- oder Kaliwasserglas, sowie Kombinationen solcher Stoffe. Insbesondere bevorzugt werden Natriumverbindungen als Dotierstoff eingesetzt.

Der Gehalt der aktiven Komponente des Dotierstoffs, wie der Alkalimetallgehalt in Alkalimetallverbindungen, beispielsweise von Kalium in Kaliumcarbonat oder Natrium in Natronwasserglas, beträgt in der gebrauchsfertigen Beschichtungssuspension vorzugsweise zwischen 30 und 500 ppm, weiter vorzugsweise zwischen 50 und 400 ppm und besonders bevorzugt zwischen 80 und 300 ppm, wobei die Mengenangaben des Dotierstoffs bezogen sind auf den Gesamtfeststoffgehalt der Beschichtungssuspension nach der Pyrolyse des Bindemittels, d.h. dass das Bindemittel bei der Bestimmung des Gesamtfeststoffgehalts als SiO₂ berücksichtigt wurde.

Es ist bevorzugt, dass der Dotierstoff bei einer Temperaturbehandlung der Beschichtung zumindest teilweise transient ist, somit also nach dem Einbrennen der Beschichtung bzw. während des Einsatzes bevor das Silizium anfängt zu schmelzen, nur noch teilweise in der Beschichtung vorhanden oder fast bzw. vollständig verschwunden ist. Dadurch wird verhindert, dass der Dotierstoff in unerwünschten Mengen als Verunreinigung in den Silizium-Ingot transportiert wird.

Der Dotierstoff wird dem Dispergiermedium der Beschichtungssuspension zugegeben und liegt dort bevorzugt als nicht lösliche oder schwer lösliche Verbindung vor.

Bei porösen Solartiegeln aus Fused Silica wird ein Teil des Binders durch Kapillarkräfte in die Tiegelwand gezogen und ist somit nicht mehr Bestandteil der Beschichtung. Ebenso können bei Verwendung von SiO₂-Vorstufen, wie von metallorganischen Verbindungen (wie beispielsweise Tetraethylorthosilicat und daraus hergestellten Sol-Gel Systemen) niedermolekulare Komponenten während der Trocknung der Schicht verdampfen, so dass der effektive Bindergehalt in der Beschichtung deutlich niedriger ist als der Bindergehalt, der in der Rezeptur der Beschichtungssuspension eingestellt wird.

Der Bindungsmechanismus des durch Zugabe des Dotierstoffs modifizierten Bindemittels unterscheidet sich von Beschichtungen, in denen ein aus dem Stand der Technik bekanntes Niedrigtemperaturbindemittel eingesetzt wird. Ein Beleg dafür ist, dass weder der Dotierstoff allein noch das Bindemittel allein in der Lage sind, zusammen mit Siliziumnitrid-Pulver die erfindungsgemäßen funktionalen Siliziumnitrid-Schichten mit niedrigem Sauerstoffgehalt sowie hoher Härte und Haftfestigkeit zu erzeugen (siehe Referenzbeispiele).

Das durch Zugabe des Dotierstoffs modifizierte Bindemittel unterscheidet sich deutlich in seinen Eigenschaften von dem ursprünglichen undotierten Bindemittel. Durch die Verwendung des Dotierstoffs bei gleichzeitig niedrigen Bindergehalten entstehen weniger Spannungen in der Trennschicht, wodurch deutlich weniger Defekte in der Substratoberfläche oder in der Trennschicht entstehen, sowohl nach dem Beschichten bzw. nach dem Einbrennen als auch während des Prozesses, wie etwa sog. "chipping" (schuppiges Absplittern der Beschichtung in der gesamten Tiefe einschließlich möglicherweise von Tiegelmaterial), oder Risse und Mikrorisse oder auch die Ausbildung ganzer Rissnetzwerke. Dies wird nicht wie in DE 10 2007 053 284 A1 durch die Herabsetzung der Sinteraktivität, sondern durch die Verwendung des die Glastransformationstemperatur herabsetzenden Dotierstoffs erreicht. Dieser bewirkt bereits bei < 400°C eine Erweichung von dotierstoffreichen Bereichen in der Beschichtung und somit einen Abbau von Spannungen, die Fehler in der Trennschicht erzeugen können.

Die Beschichtungssuspension zur Herstellung der erfindungsgemäßen Formkörper mit den Siliziumnitrid-haltigen Trennschichten kann über ein Verfahren umfassend die folgenden Verfahrensschritte hergestellt werden:
1) Herstellen eines Vorprodukts A durch Mischen von Bindemittel-Rohstoffen auf SiO₂-Basis, Dispergiermedium und dem Dotierstoff,
2) Herstellen der Beschichtungssuspension durch Dispergieren von Siliziumnitrid-Pulver und ggf. Hilfsstoffen in Vorprodukt A.

Es ist möglich, die Schritte 1) und 2) zu kombinieren und das Siliziumnitrid-Pulver gemeinsam mit Bindemittel-Rohstoffen, Dotierstoff und ggf. Hilfsstoffen in einem Dispergiermedium zu dispergieren.

Ein weiteres mögliches Herstellverfahren für die Beschichtungssuspension, das beispielsweise bei Verwendung eines flüssigen Dotierstoffs eingesetzt werden kann, umfasst die folgenden Verfahrensschritte:
1) Herstellen eines Vorprodukts B durch Fällen des Dotierstoffs im Dispergiermedium und Dispergieren von Siliziumnitrid-Pulver im dotierten Dispergiermedium durch gemeinsames Vermahlen,
2) Herstellen der Beschichtungssuspension durch Homogenisierung des Vorproduktes B mit den Bindemittel-Rohstoffen auf SiO₂-Basis und ggf. Hilfsstoffen durch gemeinsames Vermahlen.

Die Bindemittel-Rohstoffe in 1) bzw. 2) der vorgenannten Verfahrensvarianten sind vorzugsweise Vorstufen des Siliziumdioxides oder Siliziumnitrids wie beispielsweise siliziumorganische Verbindungen und Hydrolyseprodukte daraus sowie Kondensationsprodukte daraus sowie Mischungen von siliziumorganischen Verbindungen, deren Hydrolyse- und Kondensationsprodukte, die über einen Sol-Gel-Prozess hergestellt werden, und/oder Salze des Siliziums wie beispielsweise Siliziumtetrachlorid, ggf. mit Zusatz von Siliziumdioxid-Nanopartikeln oder Siliziumdioxid-Partikeln im Submikronbereich.

Beispiele für geeignete siliziumorganische Verbindungen sind Tetraethylorthosilikat (TE-OS) und Methyltriethoxysilan (MTEOS). Es ist auch möglich, nur SiO₂-Nanopartikel als Bindemittel-Rohstoffe einzusetzen, ohne Zusatz von siliziumorganischen Verbindungen. Die mittlere Partikelgröße der SiO₂-Nanopartikel beträgt dabei vorzugsweise 100 nm und weniger, weiter vorzugsweise 50 nm und weniger.

Der Dotierstoff in 1) umfasst vorzugsweise eine Alkalimetall-Verbindung, insbesondere bevorzugt eine Natrium-Verbindung. Beispielsweise kann als Dotierstoff ein Alkalicarbonat wie Kalium- oder Natriumcarbonat eingesetzt werden oder auch Kali- oder Natronwasserglas.

Der Dotierstoff wird dem Dispergiermedium der Beschichtungssuspension zugegeben und liegt dort bevorzugt als nicht oder schwer lösliche Verbindung vor.

Vorzugsweise werden zwischen 30 und 500 ppm, weiter vorzugsweise zwischen 50 und 400 ppm und besonders bevorzugt zwischen 80 und 300 ppm an Dotierstoff zugegeben, wobei die Mengenangaben des Dotierstoffs bezogen sind auf den Gesamtfeststoffgehalt der Beschichtungssuspension nach der Pyrolyse des Bindemittels, d.h. dass das Bindemittel bei der Bestimmung des Gesamtfeststoffgehalts als SiO₂ berücksichtigt wurde.

Als Dispergiermedium kann Wasser und/oder ein organisches Lösemittel, beispielsweise ein Alkohol, wie Ethanol, eingesetzt werden.

Das Mischen und das Dispergieren in Schritt 1) oder 2) können beispielsweise in einer Naßaufmahlung oder anderen Mischaggregaten erfolgen.

Als Siliziumnitrid-Pulver in 2) bzw. 1) wird bevorzugt ein Pulver hoher Reinheit eingesetzt. Der Gesamtgehalt metallischer Verunreinigungen des Siliziumnitrid-Pulvers beträgt vorzugsweise weniger als 100 ppm, besonders bevorzugt weniger als 50 ppm. Der Sauerstoffgehalt des Siliziumnitrid-Pulvers beträgt bevorzugt weniger als 2 Gew.-% und der Gesamtkohlenstoffgehalt bevorzugt weniger als 0,35 Gew.-%. Die mittlere Partikel- oder Agglomeratgröße (d₅₀) des Siliziumnitrid-Pulvers liegt vorzugsweise im Bereich von 0,5-20 µm, weiter vorzugsweise von 1 - 5 µm und besonders bevorzugt von 1,5 - 3 µm.

Die Hilfsstoffe in 2) können organische Verbindungen wie beispielsweise Polyvinylbutyral (PVB), Polyvinylalkohol (PVA), Polyethylenglykol (PEG), Wachse oder ethanollösliche Polymere sein.

Der Feststoffgehalt in der Beschichtungssuspension liegt für die Applikation durch Fluten geeigneterweise bei 40 bis 65 Gew.%, für die Applikation durch Nass-in-Nass-Sprühen bei 35 bis 55 Gew.%.

Das Auftragen der hergestellten Suspension in Schritt c) des Verfahrens zur Herstellung der erfindungsgemäßen Formkörper erfolgt mit gängigen Beschichtungsverfahren wie Sprühen (bevorzugt nass in nass) oder Fluten auf einem anorganischen Substrat (wie beispielsweise Fused Silica).

Die Ausbildung der Trennschicht des erfindungsgemäßen Formkörpers in Schritt d) erfolgt geeigneterweise durch Einbrennen der Beschichtung bei 300° - 1300°C, bevorzugt bei 900°C - 1200°C, weiter vorzugsweise bei 1000°C - 1100°C, unter Luft oder mit niedrigem Sauerstoffpartialdruck, oder bei reduzierender oder inerter Atmosphäre bei 800°C-1750°C, bevorzugt bei 1000°C - 1725°C und besonders bevorzugt bei 1100 - 1700°C, oder unter Gasdruck (z.B. Stickstoff, Argon) bei 1000°C - 2000°C, bevorzugt bei 1500°C-1900°C und besonders bevorzugt bei 1600°C - 1800°C. Die Aufheiz- und Abkühlzeit beträgt dabei beispielsweise jeweils 8 Stunden, die Haltezeit bei Maximaltemperatur vorzugsweise etwa eine Stunde. Ein Einbrennen der Beschichtung in einem gasbefeuerten Ofen mit niedrigem Sauerstoffpartialdruck ist bevorzugt, da dann das Siliziumnitrid in der Beschichtung weniger stark oxidiert.

Die Verwendung hochreiner Ausgangschemikalien (Siliciumnitrid-Pulver, siliziumorganische Verbindungen, Alkohole, etc.) ist bevorzugt, da hierbei höchstreine Schichten erhalten werden können, die insbesondere den Anforderungen der Solarindustrie gerecht werden.

Bei den erfindungsgemäßen Formkörpern besteht das Substrat geeigneterweise aus Keramik, einschließlich Siliciumnitrid-Keramik, oder SiO₂ (fused silica) oder auch Fasermatten oder Gewebe. Bei einer bevorzugten Ausführungsform handelt es sich bei dem Formkörper um einen Schmelztiegel mit einem Substrat aus SiO₂ (fused silica), welcher sich für die Verarbeitung korrosiver Nichteisenmetallschmelzen, insbesondere Siliziumschmelzen eignet.

### Beispiele und Vergleichsbeispiele

### Härtemessung nach Brinell:

Die Härte der Beschichtungen wird hierin als Brinell-Härte gemäß DIN EN ISO 6506-1 ermittelt, mit einem Kugeldurchmesser von 2,5 mm und einer Last von 3 kg.

### Abzugstest (Haftfestigkeit):

Die Haftfestigkeit wurde durch die Messung der Kraft, die zum Abzug einer auf die eingebrannte Beschichtung einer beschichteten Probe geklebte Platte benötigt wird, durchgeführt (Klebefläche 500 mm²). Die Platte wurde mit einem Zweikomponenten-Epoxidharzkleber aufgeklebt, der durch seine hohe Viskosität maximal 50 - 80µm in die Beschichtungen eindringt. Ermittelt wurde die Haftfestigkeit senkrecht zur Schichtoberfläche in N/mm². Die Schichtdicke der getesteten beschichteten Proben lag zwischen 150 und 250 µm.

### Bestimmung von Gesamtsauerstoffgehalt und Natriumgehalt der Beschichtung:

Die Beschichtungen wurden mit einem Siliziumnitrid-Schaber abgetragen, und das so erhaltene Pulver wurde dann ohne Trocknen zur Analyse verwendet. Der Gesamtsauerstoffgehalt wurde mittels Trägergasheißextraktion bestimmt. Der Natriumgehalt wurde mittels optischer Emissionsspektrometrie mit induktiv gekoppeltem Plasma und elektrothermischer Verdampfung (ETV-ICP OES) ermittelt.

### Vergleichsbeispiel 1: Standardsuspension

Es werden 50 Gew.-% Siliziumnitridpulver (UBE E10) in Ethanol homogenisiert. Die Suspension wird auf den gereinigten, staubfreien, trockenen Fused-Silica-Tiegel aufgebracht. Die Beschichtung des Tiegels mittels Fluten ist nicht möglich, da bereits ab einer Schichtdicke von 150 - 200µm in der Beschichtung während der Trocknung Risse entstehen, was zu einer flächigen Ablösung der Beschichtung vor dem Einbrennen der Beschichtung führt. Die Benetzung des Tiegels mit Ethanol vor der Applikation konnte diesen Effekt nicht verhindern. Auch bei der Zugabe von 2% PVA Celvol E 04/88 (Celanese Emulsions GmbH) in die Ethanol-Siliziumnitrid-Suspension können keine rissfreien Schichtdicken von > 250 µm bei einer Applikation per Fluten erzielt werden. Der Sauerstoffgehalt der Beschichtung findet sich in Tabelle 1, die Ermittlung der Härte war nicht möglich.

### Vergleichsbeispiel 2: Standardsuspension

Es werden 50 Gew.-% Siliziumnitridpulver (UBE E10) in Ethanol homogenisiert. Die Suspension wird auf den gereinigten, staubfreien, trockenen Fused-Silica-Tiegel aufgebracht. Die Beschichtung wird durch Sprühen aufgetragen. Es zeigte sich, dass ein Nass-in-Nass-Sprühen der Suspension nicht möglich ist, da ab einer Schichtdicke von ca. 200µm Risse in der Beschichtung entstehen. Die Beschichtungen werden pulverig aufgesprüht.

Nach der Trocknung werden die Beschichtungen vor dem Einsatz als Schmelztiegel bei ca. 1000°C eingebrannt. Die so hergestellte Siliziumnitrid-Schicht ist nur bedingt berührungsfest und sollte entsprechend sorgsam behandelt werden.
Die Haftfestigkeit der Beschichtung beträgt 0,18 N/mm², die Härte 2 HBW 2,5/3 (siehe Tabelle 1).

### Vergleichsbeispiel 3 :

Es wurde eine Beschichtungssupension hergestellt gemäß WO 2007/039310 A1, Beispiel 1b. Die Beschichtung wurde über pulvriges Sprühen oder Fluten aufgetragen und bei 500 °C (3a) und 750°C (3b) eingebrannt.

Die Beschichtung ist nach dem Einbrennen pulvrig und nicht berührungsfest.
Für die pulvrig aufgesprühten Beschichtungen sind der Sauerstoffgehalt, die Härte und die Haftfestigkeit der Beschichtung in Tabelle 1 angegeben.

Bei der Beschichtung über Fluten reißt die Beschichtung bei einer Schichtdicke von > 80 - 150 µm bereits beim Trocknen oder Einbrennen und löst sich ab, daher konnte hier keine Haftfestigkeit gemessen werden und auch die Messung der Härte war nicht möglich.

### Vergleichsbeispiel 4:

Es wird eine Beschichtung gemäß DE 10 2005 050 593 A1 hergestellt.

Dazu werden 600 g Siliziumnitrid-Pulver (H.C. Starck, M11 h.p., mittlere Partikelgröße d₅₀ < 1µm, gemessen mit Mastersizer 2000, Malvern) in einem Gemisch aus 900 g Ethanol und 95 g des Binders Inosil S38, Inomat GmbH, Deutschland (mit einem SiO₂-Feststoffgehalt im Glührückstand von 33 Gew.-%) auf dem Rollenbock in einem PE-Fass mit Siliziumnitridmahlkugeln für fünf Stunden dispergiert. Die Suspension enthält 38 Gew.-% Siliziumnitrid. Die Suspension wird per Fluten auf einem Fused Silica Solartiegel mit einer Schichtdicke von 100 µm appliziert. Nach der Trocknung wird die Schicht bei 500 °C für 30 Minuten eingebrannt. In Tabelle 1 sind der Sauerstoffgehalt, die Härte und die Haftfestigkeit der Beschichtung angegeben.

### Vergleichsbeispiel 5 :

Es wird eine Beschichtung gemäß DE 10 2005 050 593 A1 hergestellt.

Dazu werden 600g Siliziumnitrid-Pulver (H.C. Starck, M11 h.p., d₅₀ < 1µm) in einem Gemisch aus 800g Ethanol und 190g des Binders Inosil S38, Inomat GmbH, Deutschland (mit einem SiO₂-Feststoffgehalt im Glührückstand von 33 Gew.-%) auf dem Rollenbock in einem PE-Fass mit Siliziumnitridmahlkugeln für fünf Stunden dispergiert. Die Suspension enthält 38 Gew.-% Siliziumnitrid. Die Suspension wird per Fluten auf einem Fused Silica Solartiegel mit einer Schichtdicke von 100 µm appliziert. Nach der Trocknung wird die Schicht bei 500°C für 30 Minuten eingebrannt. In Tabelle 1 sind der Sauerstoffgehalt, die Härte und die Haftfestigkeit der Beschichtung angegeben.

### Vergleichsbeispiel 6:

Es wird eine Beschichtung gemäß DE 10 2007 053 284 A1 hergestellt.

2450g Inosil S-B Binder (Inomat GmbH, mit einem SiO₂ Feststoffgehalt im Glührückstand von 33 Gew.-%), 1200g Ethanol, 4580g Siliziumnitrid UBE E10 und 200g PVB werden mit Siliziumnitridmahlkugeln in einem PE-Behälter in Form einer Suspension homogenisiert. Die Suspension wird durch Sprühgranulation in ein Granulat überführt. Nach einer Glühung des Granulats an Luft bei 450°C wird eine einstündige Glühung im geschlossenen Tiegel bei 900°C durchgeführt. 750g des geglühten Granulats werden in 500g Ethanol mit Mahlkugeln homogenisiert und in Form einer Suspension auf eine Agglomeratgröße von 4 µm aufgemahlen. Die Suspension wird per Fluten auf einem Fused Silica Tiegel mit einer Schichtdicke von 350 µm appliziert. Die Schicht wird an Luft getrocknet und mit einer Aufheiz- und Abkühlzeit von jeweils 8 Stunden eine Stunde bei 1125°C in einem gasbefeuerten Ofen eingebrannt. In Tabelle 1 sind der Sauerstoffgehalt, die Härte und die Haftfestigkeit der Beschichtung angegeben.

### Referenzbeispiel 1: Binderfreie Beschichtung

Es werden 12 g Natronwasserglas (8% Feststoff, ulta pure) durch Eintropfen bei starkem Rühren in 462 g Ethanol gefällt. In der Dispersion werden 1150 g Siliziumnitridpulver (HC Starck M11 h.p. coarse, d₅₀ = 1,9 µm, gemessen mit Mastersizer 2000, Malvern) mit Siliziumnitrid-Mahlkugeln in einem PE-Behälter auf dem Rollenbock 6 Stunden zur Herstellung der Beschichtungssuspension homogenisiert. Die Dotierung mit Natrium beträgt 200 ppm, bezogen auf den Gesamtfeststoffgehalt der Beschichtungssuspension. Der Gesamtfeststoffgehalt der Suspension beträgt 66 Gew.-%. Die Beschichtungssuspension wird durch einmaliges Fluten auf einem Fused Silica-Tiegel mit einer Schichtdicke von ca. 200 µm appliziert. Die Schicht wird 24 Stunden an Luft getrocknet und anschließend mit einer Aufheiz- und Abkühlgeschwindigkeit von 2,3 °C/min eine Stunde bei 1100°C eingebrannt. Die Beschichtung ist nicht berührfest.

Der Gesamtsauerstoffgehalt der Beschichtung ist in Tabelle 1 aufgeführt.
Die Messung der Härte der Beschichtung war nicht möglich, da sich die eingebrannte Beschichtung schon während der Messung von dem Substrat löste. Aus dem gleichen Grund konnte auch keine Haftfestigkeit bestimmt werden.

### Referenzbeispiel 2: Beschichtung mit Bindemittel ohne Dotierung

Es werden 1090 g Siliziumnitridpulver (HC Starck M11 h.p. coarse, d₅₀ = 1,9 µm, gemessen mit Mastersizer 2000, Malvern) mit Siliziumnitrid-Mahlkugeln in 462 g Ethanol in einem PE-Behälter auf dem Rollenbock 6 Stunden homogenisiert. Durch Zugabe von 174 g Inosil S-P (Type Inosil S-P 38, Fa. Inomat, Deutschland) mit 34,5 Gew.-% resultierendem SiO₂-Feststoff nach Trocknung und Pyrolyse (Glührückstand) und weiteren 4 Stunden Homogenisierung entsteht die Beschichtungssuspension. Der resultierende SiO₂-Feststoffgehalt aus dem Binder in der Beschichtungssuspension beträgt 5 Gew.-%. Der Gesamtfeststoffgehalt der Suspension beträgt 66 Gew.-%, bezogen auf den Glührückstand des Binders (nach Trocknung und Pyrolyse). Die Beschichtungssuspension wird durch einmaliges Fluten auf einen Fused Silica-Tiegel mit einer Schichtdicke von ca. 180 µm appliziert. Die Schicht wird 24 Stunden an Luft getrocknet und anschließend mit einer Aufheiz- und Abkühlgeschwindigkeit von 2,3°C/min eine Stunden bei 1100°C eingebrannt. Die Beschichtung ist nicht berührfest.

Der Gesamtsauerstoffgehalt der Beschichtung ist in Tabelle 1 aufgeführt.
Die Messung der Härte der Beschichtung war nicht möglich, da sich auch hier die eingebrannte Beschichtung schon während der Messung von dem Substrat löste. Aus dem Grund konnte auch keine Haftfestigkeit bestimmt werden.

### Referenzbeispiel 3 :

Vergleichsbeispiel 3 wurde wiederholt, jedoch wurde der Bindergehalt auf 4 Gew.-% reduziert. Die Beschichtung wurde über pulvriges Sprühen aufgetragen und bei 500 °C eingebrannt.

Der Gesamtsauerstoffgehalt der eingebrannten Beschichtung ist in Tabelle 1 aufgeführt. Die Beschichtung ist nicht berührfest. Die Messung der Härte und Haftung der Schicht konnten nicht durchgeführt werden, da die Schicht während der Probenpräparation abplatzte.

### Beispiel 1:

Es werden 12 g Natronwasserglas (8 % Feststoff, ulta pure) durch Eintropfen bei starkem Rühren in 462 g Ethanol gefällt. In der Dispersion werden 1090 g Siliziumnitridpulver (HC Starck M11 h.p. coarse, d₅₀ = 1,9 µm, gemessen mit Mastersizer 2000, Malvern) mit Siliziumnitrid-Mahlkugeln in einem PE-Behälter auf dem Rollenbock 2 Stunden homogenisiert. Durch Zugabe von 174 g Inosil S-P (Type Inosil S-P 38, Fa. Inomat GmbH, 34,5 Gew.-% resultierender SiO₂-Feststoff nach Trocknung und Pyrolyse) und weiteren 4 Stunden Homogenisierung entsteht die Beschichtungssupension. Der resultierende SiO₂-Feststoffgehalt aus dem Binder in der Beschichtungssuspension beträgt 5 Gew.-%. Die Dotierung mit Natrium beträgt 200 ppm, bezogen auf den Gesamtfeststoffgehalt der Beschichtungssuspension nach der Pyrolyse des Binders. Der Gesamtfeststoffgehalt der Suspension beträgt 66 Gew.-%, bezogen auf den Glührückstand des Binders (nach Trocknung und Pyrolyse).

Die Beschichtungssuspension wird durch einmaliges Fluten auf einen Fused Silica-Tiegel mit einer Schichtdicke von ca. 150 µm appliziert. Die Schicht wird 24 Stunden an Luft getrocknet und anschließend mit einer Aufheiz- und Abkühlgeschwindigkeit von 2,3°C/min eine Stunden bei 1100°C eingebrannt. Die Beschichtung ist defektfrei und nicht pulverig.

### Beispiele 2-23:

Weitere erfindungsgemäße Beispiele werden analog zu Beispiel 1 mit unterschiedlichen Anteilen an Binder und Dotierstoff hergestellt und bei unterschiedlichen Temperaturen eingebrannt. Die Versuchsergebnisse sind in Tabelle 1 dargestellt.

In Tabelle 1 sind die Beispiele Nr. 1 bis 23 erfindungsgemäß, die Beispiele V1 bis V6 sind Vergleichsbeispiele, die Beispiele R1 bis R3 sind Referenzbeispiele.

Die in der Tabelle 1 angegebenen Werte für Bindergehalt (Gehalt des SiO₂-basierten Bindemittels) und Na-Dotierung beziehen sich jeweils auf die Beschichtungssuspension. Außerdem ist in Tabelle 1 die jeweilige Einbrenntemperatur der Beschichtung angegeben sowie die an der eingebrannten Beschichtung gemessenen Werte für Sauerstoff- und Natriumgehalt sowie Härte und Haftfestigkeit.

**Tabelle 1:**

| Beispiel Nr. | Bindergehalt [Gew.-%] | Na-Dotierung [ppm] | Einbrenntemperatur [°C] | Na-Gehalt [ppm] | Gesamtsauerstoffgehalt [Gew.-%] | Brinell-Härte [HBW 2,5/3] | Haftfestigkeit [N/mm²] |
|---|---|---|---|---|---|---|---|
| 1 | 5 | 200 | 1100 | 6 | 4,9 | 29 | 0,92 |
| 2 | 2 | 150 | 1100 | 6 | 4,8 | 15 | 0,30 |
| 3 | 4 | 150 | 1100 | 4 | 4,6 | 20 | 0,47 |
| 4 | 5 | 50 | 300 | 30 | 1,7 | 12 | 0,39 |
| 5 | 5 | 50 | 500 | 26 | 1,9 | 14 | 0,22 |
| 6 | 5 | 50 | 750 | 22 | 2,1 | 15 | 0,38 |
| 7 | 5 | 50 | 1000 | 3 | 3,1 | 17 | 0,26 |
| 8 | 5 | 50 | 1100 | 2 | 4,5 | 26 | 0,16 |
| 9 | 5 | 120 | 1100 | 4 | 4,5 | 28 | 0,74 |
| 10 | 5 | 150 | 300 | 111 | 1,8 | 13 | 0,57 |
| 11 | 5 | 150 | 500 | 94 | 1,8 | 16 | 0,78 |
| 12 | 5 | 150 | 750 | 79 | 2,3 | 18 | 1,02 |
| 13 | 5 | 150 | 1000 | 6 | 3,6 | 22 | 0,71 |
| 14 | 5 | 150 | 1100 | 5 | 4,9 | 25 | 1,29 |
| 15 | 5 | 200 | 300 | 119 | 1,7 | 16 | 0,33 |
| 16 | 5 | 200 | 500 | 108 | 1,9 | 18 | 0,69 |
| 17 | 5 | 200 | 750 | 98 | 2,1 | 19 | 0,95 |
| 18 | 5 | 200 | 1000 | 9 | 3,9 | 28 | 0,71 |
| 19 | 5 | 350 | 1100 | 14 | 7,0 | 29 | 0,21 |
| 20 | 6 | 150 | 1100 | 4 | 4,7 | 28 | 0,71 |
| 21 | 3 | 150 | 1100 | 7 | 3,7 | 16 | 0,23 |
| 22 | 8 | 150 | 500 | 70 | 4,0 | 22 | 1,03 |
| 23 | 8 | 150 | 1100 | 7 | 4,2 | 30 | 1,69 |
| | | | | | | | |
| V1 | 0 | 0 | 1000 | n.a.*) | 2,8 | n.m.**) | n.m.**) |
| V2 | 0 | 0 | 1000 | n.a.*) | 2,8 | 2,0 | 0,18 |
| V3a | 15 | 0 | 500 | n.a.*) | 8,6 | 2,7 | 0,23 |
| V3b | 15 | 0 | 500 | n.a.*) | 8,9 | 3,0 | 0,27 |
| V4 | 5 | 0 | 500 | n.a.*) | 1,9 | 6,4 | 1,77 |
| V5 | 10 | 0 | 500 | n.a.*) | 2,8 | 8,0 | 0,64 |
| V6 | 15 | 0 | 1100 | n.a.*) | 9,2 | 6,7 | 0,56 |
| R1 | 0 | 150 | 1100 | 22 | 8,2 | n.m.**) | n.m.**) |
| R2 | 5 | 0 | 1100 | <1 | 4,0 | n.m.**) | n.m.**) |
| R3 | 4 | 0 | 500 | n.a.*) | 3,5 | n.m.**) | n.m.**) |

| | | | | | | | |
|---|---|---|---|---|---|---|---|
| *) nicht analysiert **) nicht messbar, da Schicht bereits vor bzw. während der Messung abgelöst war | | | | | | | |

## Patentansprüche

1. Formkörper, umfassend ein Substrat mit einer fest haftenden Trennschicht, wobei die Trennschicht 92 - 98 Gew.-% Siliziumnitrid (Si₃N₄) und 2 - 8 Gew.-% Siliziumdioxid (SiO₂) umfasst, die Trennschicht einen Gesamtsauerstoffgehalt von ≤ 8 Gew.-%, vorzugsweise < 5 Gew.-% , und eine Härte von wenigstens 10 HB 2,5/3, vorzugsweise wenigstens 15 HBW 2,5/3, weiter vorzugsweise wenigstens 20 HBW 2,5/3 gemäß DIN EN ISO 6506-1 aufweist, und wobei die Trennschicht weiterhin einen Restgehalt eines Dotierstoffes in Form eines Flussmittels enthält, wobei der Dotierstoff eine Alkalimetallverbindung, vorzugsweise eine Natriumverbindung, umfasst.

2. Formkörper nach Anspruch 1, wobei der Anteil des Dotierstoffes, ausgedrückt als Alkalimetallgehalt der Trennschicht, bis zu 150 ppm, vorzugsweise bis zu 50 ppm, beträgt.

3. Formkörper nach einem der Ansprüche 1 bis 2, wobei die Trennschicht 94 - 98 Gew.-% Si₃N₄ und 2 - 6 Gew.-% SiO₂, vorzugsweise > 95 - 97 Gew.-% Si₃N₄ und 3 bis weniger als 5 Gew.-% SiO₂ enthält.

4. Formkörper nach einem der Ansprüche 1 bis 3, wobei das Substrat aus Keramik, vorzugsweise aus SiO₂ (fused silica) besteht.

5. Verfahren zur Herstellung eines Formkörpers gemäß einem der Ansprüche 1-4, umfassend folgende Schritte:
a) Bereitstellen einer Si₃N₄ und ein Bindemittel auf SiO₂-Basis sowie einen Dotierstoff in Form eines Flussmittels umfassenden Beschichtungssuspension zur Herstellung einer fest haftenden Trennschicht, wobei der Dotierstoff der Beschichtungssuspension eine Alkalimetallverbindung, vorzugsweise eine Natriumverbindung, umfasst,
b) Vorsehen eines Substrats,
c) Auftragen der Beschichtungssuspension auf das Substrat, und
d) Härten der aufgetragenen Beschichtungssuspension durch Einbrennen bei einer erhöhten Temperatur zur Ausbildung einer fest haftenden Trennschicht.

6. Verfahren nach Anspruch 5, wobei Schritt a) die folgenden Teilschritte umfasst:
1) Herstellen eines Vorprodukts A durch Mischen von Bindemittel-Rohstoffen auf SiO₂-Basis, Dispergiermedium und dem Dotierstoff,
2) Herstellen der Beschichtungssuspension durch Dispergieren von Siliziumnitrid-Pulver und ggf. Hilfsstoffen in Vorprodukt A.

7. Verfahren nach Anspruch 5, wobei Schritt a) die folgenden Teilschritte umfasst:
1) Herstellen eines Vorprodukts B durch Fällen des Dotierstoffs im Dispergiermedium und Dispergieren von Siliziumnitrid-Pulver im dotierten Dispergiermedium durch gemeinsames Vermahlen,
2) Herstellen der Beschichtungssuspension durch Homogenisierung des Vorproduktes B mit den Bindemittel-Rohstoffen auf SiO₂-Basis und ggf. Hilfsstoffen durch gemeinsames Vermahlen.

8. Verfahren nach Anspruch 6 oder 7, wobei die Beschichtungssuspension eine Suspension von Feststoffteilchen und dem Dotierstoff umfasst, wobei die Feststoffteilchen 88 - 98 Gew.-% Siliziumnitrid und 2 - 12 Gew.-% eines SiO₂-basierten Bindemittels umfassen.

9. Verfahren nach einem der Ansprüche 5 bis 8, wobei das SiO₂-basierte Bindemittel aus partikulärem SiO₂ und/oder aus Verbindungen, die durch Einbrennen bei Temperaturen oberhalb 300°C SiO₂ bilden, besteht.

10. Verfahren nach einem der Ansprüche 5 bis 9, wobei das Siliziumnitrid eine mittlere Partikel- oder Agglomeratgröße (d₅₀) im Bereich von 0,5 - 20 µm, vorzugsweise von 1 - 5 µm und besonders bevorzugt von 1,5 - 3 µm aufweist.

11. Verfahren nach einem der Ansprüche 5-10, wobei der Alkalimetall-Gehalt der Beschichtungssuspension zwischen 30 und 500 ppm, weiter vorzugsweise zwischen 50 und 400 ppm und besonders bevorzugt zwischen 80 und 300 ppm beträgt, und wobei die Mengenangaben des Dotierstoffs bezogen sind auf den Gesamtfeststoffgehalt der Beschichtungssuspension nach der Pyrolyse des Bindemittels.

12. Verfahren nach einem der Ansprüche 5 bis 11, wobei der Dotierstoff in der Beschichtungssuspension als nicht lösliche oder schwer lösliche Verbindung vorliegt.

13. Verfahren nach einem der Ansprüche 5 bis 12, wobei das Härten in Schritt d) durch Einbrennen der Beschichtung bei 300° - 1300°C, bevorzugt bei 900°C - 1200°C, weiter vorzugsweise bei 1000°C - 1100°C, unter Luft oder mit niedrigem Sauerstoffpartialdruck erfolgt.

14. Beschichtungssuspension zur Verwendung in einem Verfahren zur Herstellung eines Formkörpers gemäss Anspruch 5, umfassend eine Suspension von Feststoffteilchen und einem Dotierstoff in Form eines Flussmittels in einem Dispergiermedium, wobei die Feststoffteilchen 88-98 Gew.-% Si₃N₄ und 2-12 Gew.-% eines SiO₂-basierten Bindemittels umfassen.

15. Verwendung eines Formkörpers gemäß einem der Ansprüche 1 bis 4 auf dem Gebiet der korrosiven Nichteisenmetallschmelzen, insbesondere die Verwendung eines Formkörpers in Form eines Schmelztiegels zur Herstellung von Siliziumschmelzen.

## Claims

1. A shaped body comprising a substrate with a firmly adhering separation layer, wherein the separation layer comprises 92 - 98 wt. % silicon nitride (Si₃N₄) and 2 - 8 wt. % silica (SiO₂), the separation layer comprises a total oxygen content of ≤ 8 wt. %, preferably < 5 wt. %, and a hardness of at least 10 HB 2.5/3, preferably at least 15 HBW 2.5/3, more preferably at least 20 HBW 2.5/3 in accordance with DIN EN ISO 6506-1, and wherein the separation layer furthermore contains a residual content of a dopant in the form of a fluxing agent, wherein the dopant comprises an alkali metal compound, preferably a sodium compound.

2. The shaped body according to claim 1, wherein the proportion of the dopant, expressed as alkali metal content of the separation layer, is up to 150 ppm, preferably up to 50 ppm.

3. The shaped body according to any of claims 1 to 2, wherein the separation layer contains 94 - 98 wt. % Si₃N₄ and 2 - 6 wt. % SiO₂, preferably > 95 - 97 wt. % Si₃N₄ and 3 to less than 5 wt. % SiO₂.

4. The shaped body according to one of claims 1 to 3, wherein the substrate consists of ceramic, preferably of SiO₂ (fused silica).

5. A method for producing a shaped body according to one of claims 1 to 4, comprising the following steps:
a) Providing a coating suspension for the production of a firmly adhering separation layer, the coating suspension comprising Si₃N₄ and a binder on the basis of SiO₂ as well as a dopant in the form of a fluxing agent, wherein the dopant of the coating suspension comprises an alkali metal compound, preferably a sodium compound,
b) Providing a substrate,
c) Applying the coating suspension onto the substrate, and
d) Hardening the applied coating suspension by burning in at an increased temperature in order to form a firmly adhering separation layer.

6. The method according to claim 5, wherein step a) comprises the following substeps:
1) Producing a precursor A by mixing the raw materials of the binder on the basis of SiO₂, a dispersing medium, and the dopant,
2) Producing the coating suspension by dispersing silicon nitride powder and possibly additives in the precursor A.

7. The method according to claim 5, wherein step a) comprises the following substeps:
1) Producing a precursor B by precipitating the dopant in a dispersing medium and by dispersing silicon nitride powder in the doped dispersing medium by jointly grinding them,
2) Producing the coating suspension by homogenizing the precursor B with the raw materials of the binder on the basis of SiO₂ and possibly additives by jointly grinding them.

8. The method according to claim 6 or 7, wherein the coating suspension comprises a suspension of solid particles and the dopant, wherein the solid particles comprise 88 - 98 wt. % silicon nitride and 2 - 12 wt. % of a SiO₂-based binder.

9. The method according to any of claims 5 to 8, wherein the SiO₂-based binder consists of particulate SiO₂ and/or compounds that form SiO₂ by burning in at temperatures above 300°C.

10. The method according to any of claims 5 to 9, wherein the silicon nitride has an average particle or agglomerate size (d₅₀) in the range of 0.5 - 20 µm, preferably of 1 - 5 µm, and particularly preferably of 1.5 - 3 µm.

11. The method according to any of claims 5 to 10, wherein the alkali metal content of the coating suspension is between 30 and 500 ppm, more preferably between 50 and 400 ppm, and particularly preferably between 80 and 300 ppm, and wherein the specifications of quantity of the dopant are related to the total solid content of the coating suspension after the pyrolysis of the binder.

12. The method according to any of claims 5 to 11, wherein the dopant is present in the coating suspension as an insoluble or hardly soluble compound.

13. The method according to any of claims 5 to 12, wherein the hardening in step d) takes place by burning in of the coating at 300° - 1300°C, preferably at 900°C - 1200°C, more preferably at 1000°C - 1100°C in air or with low oxygen partial pressure.

14. A coating suspension for use in a method for producing a shaped body according to claim 5, comprising a suspension of solid particles and a dopant in the form of a fluxing agent in a dispersing medium, wherein the solid particles comprise 88 - 98 wt. % Si₃N₄ and 2 - 12 wt. % of a SiO₂-based binder.

15. The use of a shaped body according to any of claims 1 to 4 in the field of corrosive non-ferrous metal melts, in particular the use of a shaped body in the form of a melting crucible for producing silicon melts.

## Revendications

1. Corps moulé, comprenant un substrat doté d'une couche de démoulage fortement adhésive, dans lequel la couche de démoulage comprend de 92 à 98 % en poids de nitrure de silicium (Si₃N₄) et de 2 à 8 % en poids de dioxyde de silicium (SiO₂), la couche de démoulage présente une teneur totale en oxygène de ≤ 8 % en poids, de préférence < 5 % en poids et une dureté d'au moins 10 HB 2,5/3, de préférence au moins 15 HBW 2,5/3, plus préférablement d'au moins 20 HBW 2,5/3 conformément à la norme DIN EN ISO 6506-1 et dans lequel la couche de démoulage contient en outre une teneur résiduelle d'une substance de dopage sous la forme d'un agent fluide, dans lequel la substance de dopage comprend un composé de métal alcalin, de préférence un composé de sodium.

2. Corps moulé selon la revendication 1, dans lequel la part de la substance de dopage, exprimée comme teneur en métal alcalin de la couche de démoulage, va jusqu'à 150 ppm, de préférence jusqu'à 50 ppm.

3. Corps moulé selon l'une des revendications 1 à 2, dans lequel la couche de démoulage contient de 94 à 98 % en poids de Si₃N₄ et de 2 à 6 % en poids de SiO₂, de préférence > 95 à 97 % en poids de Si₃N₄ et de 3 à moins de 5 % en poids de SiO₂.

4. Corps moulé selon l'une des revendications 1 à 3, dans lequel le substrat est constitué de céramique, de préférence de SiO₂ (silice fondue).

5. Procédé de fabrication d'un corps moulé selon l'une des revendications 1 à 4, comprenant les étapes suivantes :
a) préparer une suspension de revêtement pour la fabrication d'une couche de démoulage fortement adhésive, la suspensión de revêtement comprend Si₃N₄ et un agent liant à base de SiO₂ ainsi qu'une substance de dopage sous la forme d'un agent fluide, dans lequel la substance de dopage de la suspension de revêtement comprend un composé de métal alcalin, de préférence un composé de sodium,
b) fournir un substrat,
c) appliquer la suspension de revêtement sur le substrat et
d) durcir la suspension de revêtement appliquée par cuisson à une température plus élevée pour former une couche de démoulage fortement adhésive.

6. Procédé selon la revendication 5, dans lequel l'étape a) comprend les étapes partielles suivantes :
1) fabriquer un précurseur A par mélange de matières premières d'agent liant à base de SiO₂, d'un milieu dispersant et de la substance de dopage,
2) fabriquer la suspension de revêtement par dispersion de poudre de nitrure de silicium et, le cas échéant, d'adjuvants dans le précurseur A.

7. Procédé selon la revendication 5, dans lequel l'étape a) comprend les étapes partielles suivantes :
1) fabriquer un précurseur B par précipitation de la substance de dopage dans le milieu dispersant et dispersion de la poudre de nitrure de silicium dans le milieu dispersant dopé par co-broyage,
2) fabriquer la suspension de revêtement par homogénéisation du précurseur B avec les matières premières d'agent liant à base de SiO₂ et, le cas échéant, d'adjuvants par co-broyage.

8. Procédé selon la revendication 6 ou 7, dans lequel la suspension de revêtement comprend une suspension de particules solides et la substance de dopage, dans lequel les particules solides comprennent de 88 à 98 % en poids de nitrure de silicium et de 2 à 12 % en poids d'un agent liant à base de SiO₂.

9. Procédé selon l'une des revendications 5 à 8, dans lequel l'agent liant à base de SiO₂ est constitué de SiO₂ particulaire et/ou de composés, qui, par cuisson à des températures supérieures à 300 °C, forment du SiO₂.

10. Procédé selon l'une des revendications 5 à 9, dans lequel le nitrure de silicium présente une taille moyenne des particules ou agglomérats (d₅₀) dans la plage de 0,5 à 20 µm, de préférence de 1 à 5 µm et plus préférablement de 1,5 à 3 µm.

11. Procédé selon l'une des revendications 5 à 10, dans lequel la teneur en métal alcalin de la suspension de revêtement est comprise entre 30 et 500 ppm, plus préférablement entre 50 et 400 ppm et de manière particulièrement préférée entre 80 et 300 ppm et dans lequel les données de quantité de la substance de dopage sont par rapport à la teneur totale en solides de la suspension de revêtement après la pyrolyse de l'agent liant.

12. Procédé selon l'une des revendications 5 à 11, dans lequel la substance de dopage est présente dans la suspension de revêtement en tant que composé soluble ou difficilement soluble.

13. Procédé selon l'une des revendications 5 à 12, dans lequel la dureté à l'étape d) s'effectue par cuisson du revêtement à des températures de 300° à 1300 °C, de préférence de 900 °C à 1200 °C, de manière particulièrement préférée de 1000 °C à 1100 °C, sous air ou sous pression partielle d'oxygène faible.

14. Suspension de revêtement à utiliser dans un procédé pour la fabrication d'un corps moulé selon la revendication 5, comprenant une suspension de particules solides et une substance de dopage sous la forme d'un agent fluide dans un milieu dispersant, dans laquelle les particules solides comprennent de 88 à 98 % en poids de Si₃N₄ et de 2 à 12 % en poids d'un agent liant à base de SiO₂.

15. Utilisation d'un corps moulé selon l'une des revendications 1 à 4, dans le domaine de la fusion de métaux non ferreux, notamment l'utilisation d'un corps moulé sous la forme d'un creuset pour la fabrication de silicium en fusion.
